# FASCICULE DE BREVET EUROPEEN

(11) **EP 2 396 829 B1**
(45) Date de publication et mention de la délivrance du brevet: **02.08.2017**
(21) Numéro de dépôt: 10707851.1
(22) Date de dépôt: 12.02.2010
(51) Int. Cl.: H01L 31/052

(54) **DOUBLE VITRAGE A HAUT RENDEMENT PHOTOVOLTAIQUE**
DOPPLERVERGLASUNG MIT HOHER PHOTOVOLTAIKAUSGABE
DOUBLE GLAZING WITH A HIGH PHOTOVOLTAIC OUTPUT

(30) Priorité: 12.02.2009 FR 0900634
(43) Date de publication de la demande: 21.12.2011
(73) Titulaire: Cascade (SAS), 92140 Clamart (FR)
(72) Inventeur: GRAVISSE, Philippe Edouard, F-75015 Paris (FR); SCHIFFMANN, Marc, F-44290 Masserac (FR)
(74) Mandataire: IP Trust
(86) Numéro de dépôt international: PCT/EP2010/051810
(87) Numéro de publication internationale: WO 2010/092159

(56) Documents cités:
- WO-A-2008/110567
- WO-A-2009/049048
- DE-A1- 3 125 620
- DE-A1- 3 125 622
- US-A- 4 367 367
- US-A1- 2003 010 378
- US-A1- 2005 284 516
- US-A1- 2008 245 411

## Description

La présente invention concerne un double vitrage à haut rendement photovoltaïque, notamment destiné au bâtiment.

### Etat de la technique

On connaît dans l'état de la technique la demande de brevet US2008289621A décrivant une structure comprenant un capteur solaire allongé orientable formant un élément modulaire pour la construction d'un immeuble.

On connaît également la demande américaine US2008236654A décrivant un immeuble présentant des fenêtres extérieures revêtues d'un film photovoltaïque.

Le brevet international WO06040514A décrit un système de baie comprenant des stores vénitiens dont les lames sont revêtues par des capteurs photovoltaïques.

Le brevet international WO05067060A décrit une autre solution de fenêtre comprenant des cellules photovoltaïques.

On connaît également le brevet US2003/0010378 décrivant des feuilles de verre superposées entre lesquels sont disposés des cellules solaires. Un cadre en silicone assure l'écartement des deux feuilles de verre et l'étanchéité de l'ensemble.

Le brevet US2005/0284516 décrit également un module formé de deux vitrages entre lesquels est disposé un ensemble de cellules photovoltaïques.

Les brevet allemands DE31 25 622 ou DE3125620, ou la demande de brevet internationale 2009/049048 décrivent des structures voisines.

La demande de brevet internationale WO2008/110567 décrit un module constitué par une feuille de verre recouvrant une série de cellules photovoltaïque. Entre les deux est interposée une couche d'un matériau contenant un ou plusieurs matériaux photoluminescents.

La demande de brevet US2008/24511 décrit une structure de génération photovoltaïque comportant au moins un empilement de plaques dopées où chaque plaque contient un dopant particulier. La lumière est diffusée dans la tranche et va exciter des cellules périphériques. La lumière incidente traverse successivement un filtre passe-bande puis chacune des couches et interagit avec les dopants qu'elle contient, avec absorption dans les couches consécutives.

La présente invention propose un double vitrage à haut rendement photovoltaïque, destiné notamment à des bâtiments, assurant une transparence convenable et comprenant des moyens de conversion photoélectrique ne masquant pas la visibilité.

### Résumé de l'invention

A cet effet, l'invention concerne selon son acception la plus générale une baie à double vitrage selon la revendication 1. Selon une variante, les feuilles transparentes sont traitées pour réfléchir au moins partiellement les longueurs d'onde dans l'une au moins des bandes comprises entre 750 et 950 nm, 600 à 750 nm, ou 800 à 950 nm.

Selon une autre variante, les feuilles transparentes sont traitées pour produire des réflexions internes multiples dans la plage de plus grande sensibilité des cellules photovoltaïques.

Avantageusement, les cellules photovoltaïques sont revêtues d'une cascade lumineuse.

### Description succincte des figures

D'autres avantages et caractéristiques de l'invention apparaîtront à la lecture de la description qui suit, se référant aux figures annexées où :
La figure 1 représente une vue en coupe d'un exemple de réalisation d'une baie à double vitrage selon l'invention ;
La figure 2 représente une vue en coupe d'un exemple de réalisation d'une baie à double vitrage ne faisant pas partie de l'invention ;
La figure 3 illustre le principe des cascades lumineuses ;
La figure 4 représente une vue partielle en 3D d'un exemple de réalisation d'une baie à double vitrage ne faisant pas partie de l'invention ;
La figure 5 représente une vue partielle en 3D d'un autre exemple de réalisation d'une baie à double vitrage ne faisant pas partie de l'invention ;
La figure 6 représente une vue d'une baie à double vitrage selon un exemple de réalisation ne faisant pas partie de l'invention.

### Description Détaillée

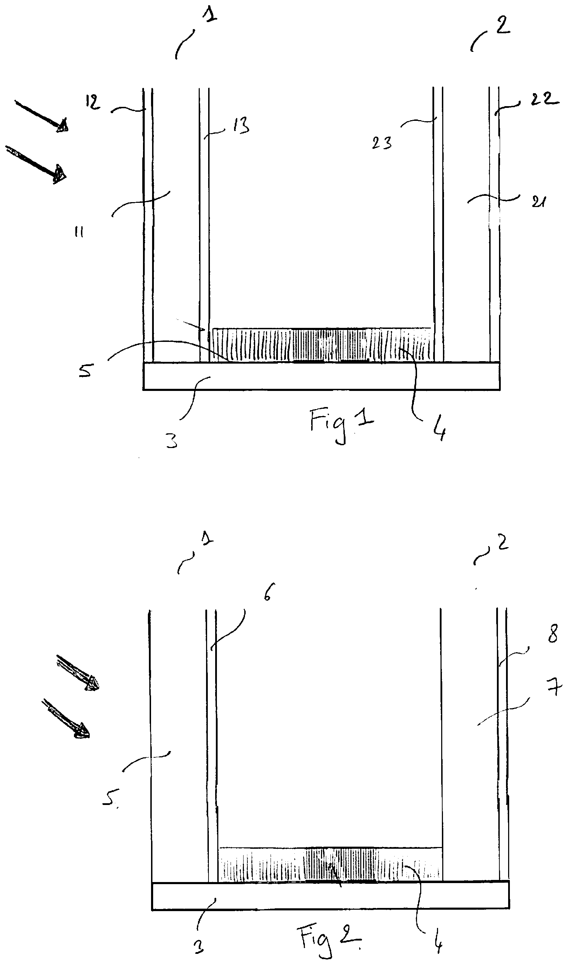

La figure 1 représente un exemple de réalisation d'une baie à double vitrage selon l'invention.

Elle comprend deux feuilles ou vitrages 1, 2 montées sur un cadre ou châssis 3, par exemple en aluminium, PVC ou bois. Des cellules ou modules photovoltaïques 4 sont disposées sur une partie au moins de la feuillure intérieure 5, perpendiculaire aux vitrages. La largeur de la feuillure est dimensionnée pour permettre le positionnement de cellules de largeur habituelle. Une alternative consiste à déposer sur la feuillure des cellules 4 en forme de ruban. Chacun des vitrages 1, 2 comprend par exemple une vitre (11, 21) typiquement d'une épaisseur de 6 millimètres pour le verre extérieur 11 et de 4 millimètres pour le verre 21 intérieur. Dans la figure 1, le vitrage extérieur 1 correspond au vitrage destiné à recevoir la lumière du soleil symbolisé par des flèches.

Selon un mode de réalisation, chacun des verres 11, 21 est revêtu du coté de la face extérieure ou intérieure par un revêtement formant un filtre dichroïque passe bas. Dans cet exemple, il s'agit par exemple des faces extérieures 12, 22. Ce filtre 12, 22 laisse passer la lumière dans le spectre solaire utile pour la photoconversion. Par exemple pour des cellules photovoltaïque de type silicium multi ou mono cristallin, le spectre de transmission du filtre 12, 22 est compris entre 300 et 950 nanomètres. Le filtre 12, 22 est réflecteur pour les longueurs d'onde supérieures à 950 nanomètres.

Selon un mode de réalisation, une des faces de chaque verre (11, 21) comporte par ailleurs un revêtement dopé 13, 23 formé par un substrat transparent, par exemple une résine acrylique, avec des charges photoluminescences formant des cascades lumineuses, l'émission de la première correspondant à l'absorption de la seconde, cette dernière réémettant à une longueur d'onde correspondant à l'absorption d'un troisième dopant, et ainsi de suite.

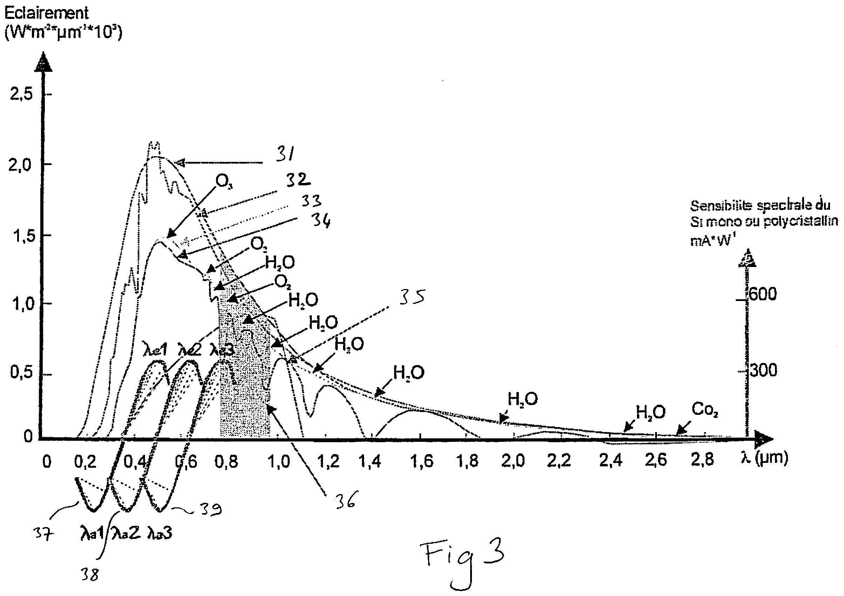

La figure 3 illustre le principe des cascades lumineuses. La courbe 31 représente la courbe d'énergie du corps noir à 6000 K, la courbe 32 illustre le rayonnement solaire hors atmosphère, la courbe 33 illustre le rayonnement solaire au niveau de la mer, la courbe 34 illustre le rayonnement solaire au niveau de la mer tenant compte de l'absorption due à la vapeur d'eau ainsi que de la présence de certains gaz, la courbe 35 illustre la réponse spectrale d'une cellule photovoltaïque en Silicium (Si) mono ou polycristallin et la zone 36 la plage de sensibilité spectrale maximum de la photopile Si mono ou polycristallin. Les courbes 37 à 39 illustrent les courbes d'absorption et d'émission de trois charges photoluminescentes de pics d'absorption respectivement **λ**ₐ1, **λ**ₐ2, **λ**ₐ3 et de pics d'émission respectivement **λ**ₑ1, **λ**ₑ2, **λ**ₑ3, où l'émission de la première correspondant à l'absorption de la seconde, et l'émission de la seconde correspondant à l'absorption de la troisième, d'où le terme de cascade lumineuse, permettant de décaler le spectre solaire vers la plage 36 de sensibilité spectrale maximum de la photopile Si mono ou polycristallin.

Selon un exemple, les cascades lumineuses absorbent la lumière dans la plage 300 à 700 nanomètres, et réémettent à une longueur d'onde d'environ 950 nanomètres.

Alternativement, les revêtements 13 et 23 forment des revêtements dichroïques et les revêtements 12, 22 des revêtements à cascade lumineuse.

Selon une variante, les revêtements 13 et 23 dichroïques et 12 et 22 cascade lumineuse peuvent être superposés d'un même coté des parois de verre pour former un revêtement à double fonction : décalage de fréquence par le matériau formant cascade lumineuse et réflecteur proche infra rouge par le dichroïque afin de piéger les photons utiles aux cellules photovoltaïques.

La figure 2 représente une variante de réalisation ne faisant pas partie de l'invention, pour une application dite de mur-rideau. La baie à double vitrage comprend une feuille de verre 5 revêtue par une résine 6 dopée avec des cascades lumineuses. La feuille de verre arrière 7 est revêtue par un matériau réfléchissant 8. Les cellules photovoltaïques 4 placés en fond de feuillure collectent la lumière diffusée par les cascades lumineuses.

Selon un exemple, la feuille de verre 7 est remplacée par une plaque en PMMA transparente (ou un matériau équivalent) dopée avec des cascades lumineuses.

Selon une autre variante, la feuille de verre 7 est revêtue par un revêtement dopé par des cascades lumineuses.

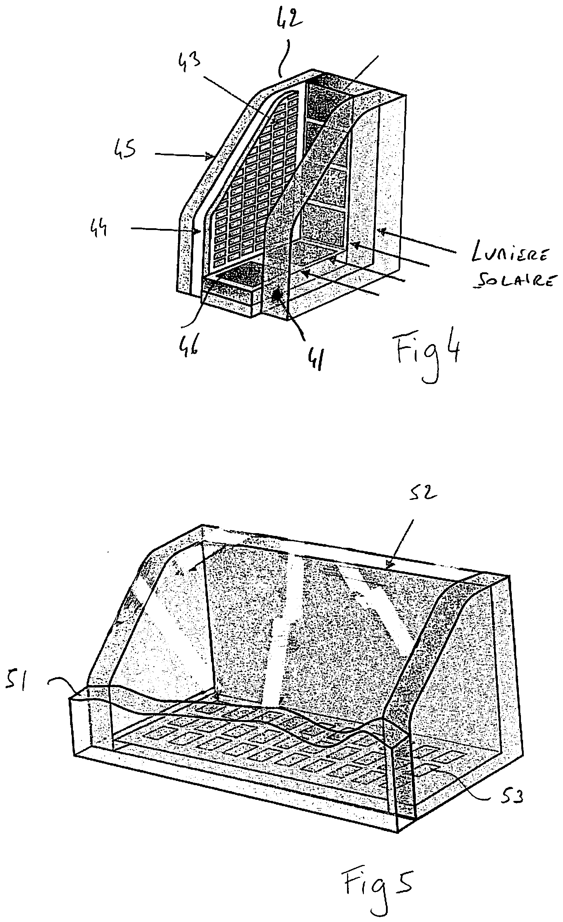

La figure 4 représente une vue partielle en 3D d'un exemple de baie photovoltaïque ne faisant pas partie de l'invention. Dans cet exemple, la face avant 41 est de type dichroïque avec coupure par exemple à 800nm. La face arrière 42 du double vitrage comprend un module photovoltaïque de type aSi thru de la société SCHOTT permettant de laisser passer la lumière, un revêtement 44 d'un matériau formant cascade lumineuse, réémettant par exemple dans la bande 550-750nm, plage de sensibilité optimale du photovoltaïque amorphe aSi Thru et une surface réflectrice blanche et/ou traitée anti-stokes 45. La surface 45 peut également être neutre dans le cas où l'on a besoin de laisser passer partiellement la lumière du soleil. En fond de feuillure du double vitrage on dispose en outre d'autre cellules photovoltaïques 46 de type aSi, qui peuvent être revêtues d'un matériau formant cascade lumineuse à réémission dans la bande 550-750nm pour améliorer encore le rendement de photocourant.

La figure 5 présente un autre exemple de réalisation d'une baie optophotovoltaïque tridimensionnelle à " générateur Si mono ou multicristallin " ne faisant pas partie de l'invention. Le verre avant 51 (ou extérieur) est par exemple dichroïque avec coupure T%/R% à 1100nm. Le verre arrière 52 (ou intérieur) est transparent, revêtu d'un matériau formant cascade lumineuse réémettant dans la bande 800-1000nm. Les modules photovoltaïques Si mono ou multicristallin 53 sont placés en fond de feuillure et peuvent être revêtus également d'un matériau formant cascade lumineuse de type réémission spectrale 800-1000nm, correspondant à la plage de plus grande sensibilité des cellules Si mono ou multicristallin.

Ces éléments, générateurs photovoltaïques, s'intègrent parfaitement aux bâtiments péri-urbains ou de grande hauteur à l'architecture desquels ils sont destinés.

Par ailleurs ces générateurs modulaires peuvent s'interconnecter entre eux pour obtenir la Puissance PW et le voltage V désirés.

Dans de tels générateurs opto-photovoltaïques, les différents éléments optoélectronique sont complémentaires et optimisés et autorisent des gains photoélectriques d'un facteur 2 par rapport aux générateurs classiques, à surface de Silicium égale et toute chose égale par ailleurs.

Les essais de laboratoire réalisés ont démontré l'efficacité des systèmes optophotovoltaïque 2D et les gains électriques attendus.

Une variante géométrique peut être introduite dans le système sous la forme d'une modification de la dimension de la feuillure interne au double vitrage pour y intégrer des modules photovoltaïques plus larges, correspondant à certaines dimensions commerciales et permettant alors une Puissance électrique délivrée supérieure. Ainsi, un double vitrage classique type 6x16x4mm avec feuillure de 16 pourrait passer à 6x160x4 avec module photovoltaïque intégrés dans la feuillure de 160mm de large produisant alors un courant délivré de facteur 10 par rapport au double vitrage photovoltaïque initial.

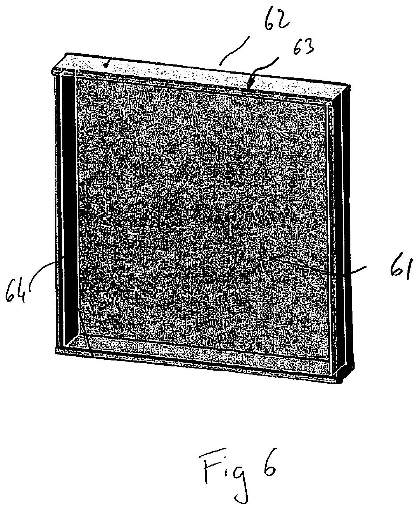

Ainsi, dans une structure de type double vitrage telle que représentée sur la figure 6, ne faisant pas partie de l'invention, constitué d'une vitre avant ou extérieure 61, d'une vitre arrière ou intérieure 62, reliées ensemble par un profilé 63 ménageant entre les deux vitres une feuillure, on se propose d'aménager chaque élément de telle sorte que le nouvel ensemble ainsi réalisé acquiert, grâce à chacun de ses nouveaux composants, l'une au moins des fonctions suivantes:
▪ Conversion photovoltaïque par les cellules Silicium amorphe, mono ou multicristallines de modules 64 disposés en fond de feuillure ou en face arrière dans le cas des modules semi transparents de type « aSi thru » de la société SCHOTT ;
▪ Collecteur de lumière par effet de diffusion et de guide d'onde ;
▪ Transformateur du spectre solaire incident par effet de " cascade Lumineuse " réémettant dans la plage de plus grande sensibilité des photopiles Si amorphe, mono ou multicristallin ;
▪ Piégeage des photons utiles par réflexions internes multiples dans la bande de plus grande sensibilité spectrale des photopiles utilisées ;
▪ Réflexion totale par réflecteur blanc polychromatique (disposé en face arrière pour former un bardage).

L'élément ainsi constitué garde ses fonctions de double vitrage classique auxquelles on ajoute la fonction de générateur photovoltaïque de haut rendement.

En effet la structure du double vitrage constitue une architecture originale et fonctionnelle de générateur photovoltaïque, tel que décrit précédemment. Ces éléments optoélectroniques sont réalisés de telle sorte qu'ils se répondent électromagnétiquement et se complètent spectralement les uns les autres dans le but de générer un courant photoélectrique élevé, de facteur 2, par rapport à un dispositif équivalent dont les composants n'auraient pas été traités optoélectroniquement par cascades lumineuses, dichroïsme, réflecteur multichrome et cellules à réponse spectrale optimisée pour l'ensemble de ce système optophotovoltaïque tridimensionnel.

Bien que décrite à travers un certain nombre d'exemples de réalisation détaillés, la baie à double vitrage selon l'invention comprend différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent.

## Revendications

1. Baie à double vitrage photovoltaïque comprenant un cadre (3) avec une feuillure (5), ladite feuillure (5) réunissant au moins deux feuilles transparentes sensiblement parallèles (1, 2), une feuille avant (1) destinée à recevoir la lumière du soleil et une feuille arrière (2), **caractérisée en ce que** la baie à double vitrage comprend des cellules photovoltaïques (4) situées en fond de feuillure perpendiculaires à la feuille avant (1) et à la feuille arrière (2) et **en ce que** les feuilles avant et arrière comportent chacune un revêtement d'un matériau comprenant des dopants optiquement actifs et formant une cascade lumineuse réémettant dans la plage de plus grande sensibilité des cellules photovoltaïques (4) et chacune un revêtement dichroïque passe bas laissant passer la lumière dans le spectre solaire utile pour la photoconversion, le revêtement d'un matériau formant une cascade lumineuse de la feuille avant étant disposé du même côté que le revêtement d'un matériau formant une cascade lumineuse de la feuille arrière, à savoir côté face intérieure ou côté face extérieure desdites feuilles, le revêtement dichroïque passe bas de la feuille avant étant disposé du même côté que le revêtement dichroïque passe bas de la feuille arrière, à savoir côté face intérieure ou côté face extérieure desdites feuilles.

2. Baie à double vitrage photovoltaïque selon la revendication 1, **caractérisée** en ce le revêtement d'un matériau formant une cascade lumineuse et le revêtement dichroïque passe-bas de chaque feuille sont disposés respectivement sur la face intérieure et sur la face extérieure desdites feuilles.

3. Baie à double vitrage photovoltaïque selon la revendication 1, **caractérisée** en ce le revêtement d'un matériau formant une cascade lumineuse et le revêtement dichroïque passe-bas de chaque feuille sont disposés respectivement sur la face extérieure et sur la face intérieure desdites feuilles.

4. Baie à double vitrage photovoltaïque selon la revendication 1, **caractérisée en ce que** le revêtement dichroïque passe bas et le revêtement d'un matériau formant une cascade lumineuse de chaque feuille sont superposés d'un même côté des feuilles, à savoir côté face intérieure ou côté face extérieure desdites feuilles.

5. Baie à double vitrage photovoltaïque selon la revendication 1, **caractérisée en ce que** les feuilles transparentes sont traitées à la fois cascades lumineuses et dichroïques pour réfléchir au moins partiellement les longueurs d'onde dans l'une au moins des bandes comprises entre 750 et 950 nm, 600 à 750 nm, ou 800 à 950 nm correspondant aux plages de plus grande sensibilité des cellules photovoltaïques.

6. Baie à double vitrage photovoltaïque selon la revendication 1, **caractérisée en ce que** les feuilles transparentes sont traitées pour produire des réflexions internes multiples dans la plage de plus grande sensibilité des cellules photovoltaïques.

## Patentansprüche

1. Fotovoltaische Doppelverglasung, die einen Rahmen (3) mit einem Falz (5) umfasst, wobei der Falz aus mindestens zwei transparenten, im Wesentlichen parallelen Folien (1, 2), einer vorderen Folie (1) für die Aufnahme der Sonne und einer hinteren Folie besteht, **dadurch gekennzeichnet, dass** die Doppelverglasung Fotovoltaikzellen (4) am Boden des Falzes senkrecht zur vorderen Folie (1) und zur hinteren Folie (2) aufweist, und dadurch, dass die vordere und die hintere Folie jeweils eine Beschichtung aus einem Material aufweisen, das optisch aktive Dotierungsstoffe umfasst und eine Lichtkaskade bildet, die in den Bereich der Fotovoltaikzellen (4) mit der größten Empfindlichkeit weiter emittiert, und jeweils eine dichroitische Tiefpassbeschichtung, die das Licht zwecks Fotoumwandlung in das nutzbare Sonnenspektrum eindringen lässt, wobei die Beschichtung der vorderen Folie aus einem Material, das eine Lichtkaskade bildet, an der gleichen Seite angeordnet ist, wie die Beschichtung der hinteren Folie aus einem Material, das eine Lichtkaskade bildet, das heißt an der Seite der Innenfläche oder an der Seite der Außenfläche der besagten Folien, wobei die dichroitische Tiefpassbeschichtung der vorderen Folie an der gleichen Seite angeordnet ist, wie die dichroitische Tiefpassbeschichtung der hinteren Folie, das heißt an der Seite der Innenfläche oder an der Seite der Außenfläche der besagten Folien.

2. Fotovoltaische Doppelverglasung gemäß Anspruch 1, **dadurch gekennzeichnet, dass** die Beschichtung mit einem Material, das eine Lichtkaskade bildet, und die dichroitische Tiefpassbeschichtung jeder Folie jeweils an der Innenseite und an der Außenseite der besagten Folien angeordnet sind.

3. Fotovoltaische Doppelverglasung nach Anspruch 1, **dadurch gekennzeichnet, dass** die Beschichtung mit einem Material, das eine Lichtkaskade bildet und die dichroitische Tiefpassbeschichtung jeder Folie jeweils an der Außenseite und an der Innenseite der besagten Folien angeordnet sind.

4. Fotovoltaische Doppelverglasung nach Anspruch 1, **dadurch gekennzeichnet, dass** die dichroitische Tiefpassbeschichtung und die Beschichtung jeder Folie mit einem Material, das eine Lichtkaskade bildet, an ein und derselben Seite der Folien übereinander gelagert sind, das heißt an der Seite der Innenfläche oder an der Seite der Außenfläche besagter Folien.

5. Fotovoltaische Doppelverglasung nach Anspruch 1, **dadurch gekennzeichnet, dass** die transparenten Folien, die so behandelt sind, dass sie Lichtkaskaden bilden und gleichzeitig dichroitisch sind, zumindest teilweise die Wellenlänge in mindestens einer der Bandbreiten zwischen 740 und 950 nm, 600 bis 750 nm oder 800 bis 950 nm entsprechend dem Bereich der höchstens Empfindlichkeit der Fotovoltaikwellen reflektieren.

6. Fotovoltaische Doppelverglasung nach Anspruch 1, **dadurch gekennzeichnet, dass** die transparenten Folien so behandelt sind, dass mehrfache interne Reflexionen im Bereich der Fotovoltaikzellen mit der höchsten Empfindlichkeit erzeugt werden.

## Claims

1. A photovoltaic double-glazed window comprising a frame (3) with a rebate (5), with the aforementioned rebate(5) combining at least two substantially parallel transparent sheets (1, 2), one front sheet (1) for receiving sunlight and one rear sheet (2), **characterised in that** the double-glazed window comprises photovoltaic cells (4) located in the base of the rebate, perpendicular to the front sheet (1) and the rear sheet (2) and **in that** the front and rear sheets each comprise a coating of a material containing optically active dopants forming a light cascade reemitting in the range of the greatest sensitivity of the photovoltaic cells (4) and each comprise a low-pass dichroic coating allowing light in the solar spectrum useful for photoconversion through, the coating of a material forming a light cascade on the front sheet is positioned on the same side as the coating of a material forming a light cascade on the rear sheet, namely on the internal side or external side of the aforementioned sheets, the low-pass dichroic coating on the front sheet is positioned on the same side as the low-pass dichroic coating on the rear sheet, namely on the internal side or external side of the aforementioned sheets.

2. A photovoltaic double-glazed window according to claim 1, **characterised in that** the coating of a material forming a light cascade and the low-pass dichroic coating on each sheet are positioned respectively on the internal side and external side of the aforementioned sheets.

3. A photovoltaic double-glazed window according to claim 1, **characterised in that** the coating of a material forming a light cascade the low-pass dichroic coating on each sheet are positioned respectively on the external side and internal side of the aforementioned sheets.

4. A photovoltaic double-glazed window according to claim 1, **characterised in that** the low-pass dichroic coating and the coating of a material forming a light cascade on each sheet are superimposed on the same side of the sheets, namely on the internal side or external side of the aforementioned sheets.

5. A photovoltaic double-glazed window according to claim 1, **characterised in that** the transparent sheets are treated as both light and dichroic cascades to at least partially reflect the wavelengths in at least one of the bands between 750 and 950 nm, 600 and 750 nm or 800 and 950 nm corresponding to the ranges of the greatest sensitivity of the photovoltaic cells.

6. A photovoltaic double-glazed window according to claim 1, **characterised in that** the transparent sheets are treated to produce multiple internal reflections in the range of the greatest sensitivity of the photovoltaic cells.
